# EUROPEAN PATENT APPLICATION

(11) **EP 2 202 330 A1**
(43) Date of publication of application: **30.06.2010**
(21) Application number: 08832666.5
(22) Date of filing: 18.09.2008
(51) Int. Cl.: C23C 14/16, A44C 27/00, C23C 14/06, C22C 5/02

(54) **ORNAMENT PARTS**

(30) Priority: 19.09.2007 JP 2007242346
(71) Applicant: Citizen Holdings Co., Ltd., Nishitokyo-shi, Tokyo 188-8511 (JP)
(72) Inventor: HAYAKAWA, Maki, Nishitokyo-shi Tokyo 188-8511 (JP); MURATA, Yasushi, Nishitokyo-shi Tokyo 188-8511 (JP)
(74) Representative: Hall, Matthew Benjamin
(86) International application number: PCT/JP2008/066890
(87) International publication number: WO 2009/038151

(57) **Abstract**

[Subject]

To provide a decorative part having a hardening layer containing Au on the surface, particularly a gold colored decorative part having gloss and color tone inherent in gold, high brightness and high quality.

[Means for problem the subject]

The decorative part of the present invention comprises a substrate and, superimposed on the substrate, a hardening layer wherein the hardening layer comprises a primary layer comprising a nitride, a carbide or a carbonitride of one or two or more metals selected from Ti, Zr and Hf, a finishing layer comprising Au or an Au alloy having an arbitrary composition such as an Au-Ni alloy, an Au-Cu-Pd alloy etc. and, disposed between the primary layer and the finishing layer, a reflecting layer comprising a metal having a higher reflectance than one constituting the finishing layer, such as Ru, Pd, Rh, Ag, Os, Ir pr Pt.

Thus, the gold colored decorative part having gloss and color tone inherent in gold, high brightness and high quality can be efficiently prepared.

## Description

### TECHNICAL FIELD

The present invention relates to a decorative part, which comprises a substrate and, superimposed on the surface thereof, a hardening layer, more specifically it relates to a decorative part having a gold colored hardening layer which surface, particularly outermost layer contains gold.

### TECHNICAL BACKGROUND

To decorative parts such as watch bands, watch cases, bezels, back cases, clasps, buckles, crowns, pierced earrings, earrings, rings, glass frames, pendants, brooches, necklaces, bracelets and the like, soft substrates which are easily processed to parts, for example, a stainless steel, Ti, a Ti alloy and brass have been used widely. The decorative parts obtainable by processing these soft substrates, however, have a problem of great proportions that during the use thereof, the appearance quality is decreased by flaw occurrence etc. This decrease is caused mainly by the low surface hardness of the soft substrates having a Vickers hardness Hv of about 200. In order to solve the problem, various surface-hardening treatments have been attempted.

Moreover, to decorative parts such as watch bands, watch cases, bezels, back cases, clasps, buckles, crowns, pierced earrings, earrings, rings, glass frames, pendants, brooches, necklaces, bracelets and the like, high decorative properties and appearance quality have been also demanded. Particularly, techniques of surface hardening treatment for securing sophisticated gold color tone have been attempted variously.

As the method of hardening a soft substrate, there is a method of forming a coating film on the surface of a soft substrate. Examples of the procedure may include wet plating and ion plating. Particularly, Au plating, Au-Ni plating, Au-Pd plating, etc. are carried out widely for decorative parts, but a coating film prepared by any plating is soft and the problem on flaws during the use can not be dissolved.

As the ion plating, a procedure of forming a titanium nitride film can be described but has a problem that the titanium nitride film has inferior adhesion because of having high internal stress and thereby peeling is easily caused. Any one of the methods cannot solve the film-peeling problems completely. Furthermore, when peeling is caused, the soft substrate itself is appeared, corrosion occurs on the appeared part with the result that it is impossible to use it as a part. When only a titanium nitride film is formed, it is difficult to use the film as decorative parts because of having low brightness, inferior sophisticated appearance but having gold colored appearance.

In order to solve the above problems, a golden decorative part having improved appearance in which an Au alloy finishing layer is formed on a titanium nitride formed film on a substrate (referred to Patent document 1 or 2). On the titanium nitride film formed on the soft substrate, a thin Au alloy layer having a thickness of not more than 1 µm is formed for purposes of preparing a golden decorative part having Au color tone. The resulting golden decorative part has high hardness and high corrosion resistance.
Patent document 1: JP-A-54(1979)-2942 (Claims 1 and 3)
Patent document 2: JP-A-2006-249510 (Claim 1)

### DISCLOSURE OF THE INVENTION

### SUBJECT TO BE SOLVED IN THE INVENTION

It is an object of the present invention to provide a golden decorative part having gloss and color tone, which are inherent in gold, and also high brightness and high quality.

### MEANS FOR THE SOLVING THE SUBJECT

In the present invention, various surface treating methods have been studied in order to solve the above subject and the present inventors found that a gold colored decorative part having gloss and color tone, which are inherent in gold, and also high brightness and high quality can be prepared by forming a hardening layer containing gold on the surface of a decorative part.

The present inventors have been studied on the structure of a hardening layer variously, and found that a gold colored hardening layer having color tone inherent in gold, high brightness and high quality can be effectively formed by employing the structure as described below.

The decorative part of the present invention comprises a substrate and a hardening layer formed on the substrate, and the hardening layer comprises a primary layer comprising a nitride, a carbide or a carbonitride of one or two or more metals selected from Ti, Zr and Hf , a finishing layer comprising Au or an Au alloy and, disposed between the primary layer and the finishing layer, a reflecting layer comprising a metal having a higher reflectance than that of the metal constituting the finishing layer.

The brightness is a criterion for showing the level of the reflectance on the surface of an object and shows brightness. The surface having high brightness is clear, while the surface having low brightness is dark. When the reflectance is high in overall visible wavelength region, the object has a clear brightness. From only the reflectance, the appearance is not confirmed as reflected light. Calculating and designing the reflectance in consideration with visual sensitivity, visual brightness, namely brightness can be obtained. This relationship is defined in JIS Z 8701 the formula (2) and JIS Z 8701 formula (1).

A TiN layer and a TiCN layer which are primary layers each have a brightness L* of about 65 to 70 and are dark films. When a finishing layer is formed on the primary layer, the color of the primary layer having low brightness reflects the color of the outermost layer because the finishing layer, formed on the outermost surface, is very thin and transmits light. Therefore, the brightness L* is about 81. (Patent documents 1 and 2 do not disclose specific values of the brightness L* in the L*a*b* color specification system defined in JIS Z 8729 regarding color tone. At this, the present inventors conducted tracing examinations and found that the Au alloy layer having a thickness of not more than 1 µm has a brightness L* of about 80 and is clearer than the nitride layer having a low brightness L* of 65 to 70. However, the Au alloy layer is darker than an Au bulk having a brightness L* of about 86.) Accordingly, forming the reflecting layer, namely, forming the reflecting layer having a high reflectance and a higher brightness than that of the finishing layer, between the finishing layer and the primary layer having a low brightness, the more beautiful color tone having a high brightness in appearance can be realized. According to the present invention, this L* can approximate to the brightness L* of about 86 of the Au bulk or the brightness L* of about 85 of an Au-Cu-Pd bulk. Specifically the brightness L* can be elevated to 82 to 84 by forming the reflection film.

The reflecting layer forming effectively improves the finishing color tone and the brightness in the decorative part having the gold colored hardening layer.

For the finishing layer, it is preferred to use pure gold and an Au-Ni alloy, an Au-Cu alloy, an Au-Cu-Pd alloy each having an arbitrary composition. Furthermore, in order to attain the high quality gold color tone and higher brightness L*, for the reflecting layer it is preferred to use a metal having a higher reflectance, such as Ru, Pd, Rh, Ag, Os, Ir and Pt.

In the decorative part of the present invention, the finishing layer has a thickness of preferably 0.002 to 0.3 µm, more preferably 0.01 to 0.1 µm. When the film thickness of the finishing layer is in the above range, there is no occurrence.of formation in an insular state caused by the thin coating so that the finishing layer is formed in a layer state and the appearance thereof has color tone free from spots. Moreover, there is no occurrence of a lowering of the hardness caused by the thick coating.

In the decorative part of the present invention, the reflecting layer has a thickness of preferably 0.001 µm to 0.01 µm. In the case the thickness of the reflecting layer is out of the above range, when it is lower than the lower limit, the change in the L* value is small, while when it is over the upper limit, the thicknesses of the reflecting layer and the finishing layer having low hardness are thicker as compared with the primary layer. As a result, the hardness is lowered. Therefore, when the thickness is in the above range, the effect of the present invention can be enhanced.

### (Function)

Since the finishing layer coated on the outermost surface is very thin and transmits light, the color of the primary layer having low brightness is reflected. Therefore, forming the reflecting layer formed from a metal having a higher reflectance than that of the finishing layer between the finishing layer and the primary layer, the higher brightness' in appearance and more beautiful color tone can be realized. Furthermore, since the color tone in appearance tends to depend on the finishing layer but the primary layer, even if the color tone of the metal used in the reflecting layer is different from that of the finishing layer, there is scarcely any possibility of effecting on the color tone.

That is to say, for example, the present invention relates to the following characteristics (1) to (15).

(1) The decorative part of the present invention comprises a substrate and, superimposed on the substrate, a hardening layer wherein the hardening layer comprises a primary layer comprising a nitride, a carbide or a carbonitride of one or two or more metals selected from Ti, Zr and Hf, a finishing layer comprising Au or an Au alloy and, disposed between the primary layer and the finishing layer, a reflecting layer comprising a metal having a higher reflectance than that of the metal constituting the finishing layer.

(2) The decorative part according to (1) is **characterized in that** the reflecting layer comprises one or two or more metals selected from Pt, Ag, Pd, Rh, Os, Ir and Ru.

(3) The decorative part according to (1) or (2) is **characterized in that** the reflective layer has a thickness of 0.001 to 0.02 µm, and the finishing layer has a thickness of 0.001 to 0.85 µm.

(4) The decorative part according to any one of (1) to (3) is **characterized in that** the finishing layer comprises Au, an Au-Ni alloy, an Au-Cu alloy or an Au-Cu-Pd alloy.

(5) The decorative part according to any one of (1) to (4) is **characterized in that** the primary layer comprises a nitride of Ti, Zr or Hf, or a carbonitride of Ti, Zr or Hf.

(6) The decorative part according to any one of (1) to (5) is **characterized in that** the substrate comprises a stainless steel, Ti, a Ti alloy, Al, an Al alloy or a Cu alloy.

(7) The decorative part according to any one of (1) to (6) is **characterized in that** the substrate having a metal layer of Hf, Ti or Zr.

(8) The process for producing a decorative part comprising a substrate and, superimposed on the substrate, a hardening layer obtainable by laminating a primary layer, a reflecting layer and a finishing layer from the substrate side, according to the present invention comprises the steps of:
a primary layer laminating step of laminating a primary layer comprising a nitride, a carbide or a carbonitride of one or two or more metals selected from Ti, Zr and Hf on the substrate,
a reflecting layer laminating step of laminating a reflecting layer comprising a metal on the primary layer, and
a finishing layer laminating step of laminating a finishing layer comprising Au or an Au alloy on the reflecting layer,
wherein the metal constituting the reflecting layer has a higher reflectance than that of the metal constituting the finishing layer.

(9) The process for producing a decorative part according to (8) is **characterized in that** the reflecting layer comprises one or two or more metals selected from Pt, Ag, Pd, Rh, Os, Ir and Ru.

(10) The process for producing a decorative part according to (8) or (9) is **characterized in that** the reflecting layer has a thickness of 0.001 to 0.02 µm, and the finishing layer has a thickness of 0.001 to 0.85 µm.

(11) The process for producing a decorative part according to any one of (8) to (10) is **characterized in that** the finishing layer comprises Au, an Au-Ni alloy, an Au-Cu alloy or an Au-Cu-Pd alloy.

(12) The process for producing a decorative part according to any one of (8) to (11) is **characterized in that** the primary layer comprises a nitride of Ti, Zr or Hf, or a carbonitride of Ti, Zr or Hf.

(13) The process for producing a decorative part according to any one of (8) to (12) is **characterized in that** the substrate comprises stainless steel, Ti, a Ti alloy, Al, an Al alloy or a Cu alloy.

(14) The process for producing a decorative part according to any one of (8) to (13) is **characterized in that** the substrate comprises a metal layer of Hf, Ti or Zr.

(15) The process for producing a decorative part according to any one of (8) to (13) is **characterized in that** the primary layer, the reflecting layer and the finishing layer are laminated by a dry plating method selected from a sputtering method, an ion plating method and an ion beam vapor deposition method.

### EFFECT OF THE INVENTION

In the present invention, as described above, the hardening layer, which comprises a primary layer comprising a nitride, a carbide or a carbonitride of one or two or more metals selected from Ti, Zr and Hf, the finishing layer comprising Au or an Au alloy and, disposed between the primary layer and the finishing layer, the reflecting layer comprising a metal having a higher reflectance than that of the finishing layer, is formed on the substrate. Since the finishing layer formed on the outermost layer has a very small film thickness and transmits light, the color of the primary layer having low brightness is reflected. Forming the reflecting layer, namely forming the reflecting layer having higher brightness than that of the finishing layer and a high reflectance between the finishing layer and the primary layer having low brightness, the higher brightness in appearance and the more beautiful color tone are realized. Therefore, the improvement in the finishing color tone and the enhancement in the brightness in the gold alloy hard film can be attained more effectively.

### BRIEF DESCRIPTION OF DRAWING

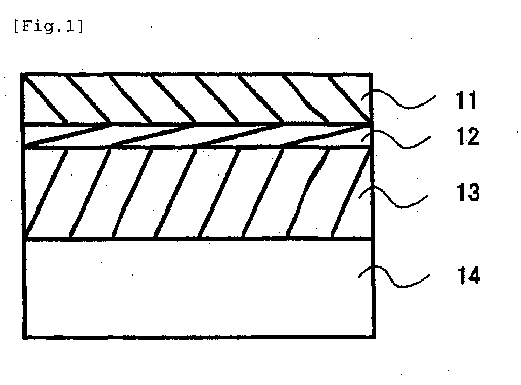

Fig. 1 is a cross sectional schematic view of a watch case as one embodiment of the decorative part according to the present invention.

### Explanation for Marks

11: Finishing layer
12: Reflecting layer
13: Primary layer
14: Substrate

### BEST EMBODIMENT FOR CARRYING OUT THE INVENTION

The embodiment of the present invention will be described with reference to the drawing. Fig. 1 is a cross sectional schematic view showing the embodiment that the hardening layer comprising the primary layer 13, the reflecting layer 12 and the finishing layer 11 is formed on the surface of a plate formed from the substrate. Employing a procedure which comprises a step of processing a base material made of a material such as a stainless, Ti and an Ti alloy into a substrate having one shape of various decorative parts, and a step of forming the hardening layer obtainable by forming the primary layer comprising a nitride, a carbide or a carbonitride of Ti, Zr or Hf, such as HfN, TiN, ZrN, TiC or TiCN, the reflecting layer comprising a metal having a higher reflectance than that of Au or an Au alloy, such as Pt, Ag or Pd on the primary layer and an Au alloy layer on the outermost surface, a decorative part having a higher brightness and excellent aesthetic appearance can be prepared.

The procedure employed herein comprises forming, as the primary layer, a HfN layer, a TiN layer, TiCN layer or a ZrN layer on a soft base material, i.e. Ti, a Ti alloy, SUS304 or SUS316L in an atmosphere of an Ar and nitrogen mixed gas plasma, and then forming, as the reflecting layer, Ru, Pd, Rh, Ag, Os, Ir or Pt in an atmosphere of an Ar and nitrogen mixed gas plasma, and successively forming, as the finishing layer, Au or an Au alloy layer on the reflecting layer in an atmosphere of an Ar and nitrogen mixed gas plasma.

The present invention is described in more detail hereinafter.

The decorative part of the present invention comprises the substrate 14 and the hardening layer superimposed on the substrate, and the hardening layer comprises the primary layer 13, the reflecting layer 12 and the finishing layer 11. Specifically, on the substrate 14, the primary layer 13, the reflecting layer 12 and the finishing layer 11 are laminated in this order.

### <Substrate>

As the substrate 14, stainless steel, Ti, a Ti alloy, Al, an Al alloy, a Cu alloy, ceramics or plastics is used. Furthermore, it is preferred to use a stainless steel, Ti, a Ti alloy, Al, an Al alloy, or a Cu alloy.

Examples of the stainless steel may include Fe-Cr alloys (specifically SUS405, SUS430, SUS434,' SUS444, SUS429, SUS430 and the like) and Fe-Cr-Ni alloys (specifically SUS304, SUS303, SUS316, SUS316L, SUS316J1, SUS316J1L and the like). Examples of the ceramics may include oxide ceramics such as Al₂O₃, SiO₂, TiO₂, Ti₂O₃, ZrO₂, Y₂O₃, barium titanate and strontium titanate; nitride ceramics such as AlN, Si₃N₄, SiN, TiN, BN, ZrN, HfN, VN, TaN, NbN, CrN and Cr₂N; carbide ceramics such as graphite, SiC, ZrC, Al₄C₃, CaC₅, WC, TiC, HfC, VC, TaC and NbC; boride ceramics such as ZrB₂ and MoB; and composite ceramics obtainable by mixing two or more kinds of these ceramics. As the plastics, conventionally known thermoplastic resins and thermosetting resins are used.

The shape of the substrate 14 is not particularly limited as far as the desired decorative part can be prepared.

### <Primary layer>

The primary layer 13 comprises a nitride, a carbide or a carbonitride of one or two or more metals selected from Ti, Zr and Hf. Forming the primary layer 13, the hardness is increased and the flaw resistance of the resulting decorative part is improved. Among them, from the viewpoint of color tone, it is preferred to use a Ti, Zr or Hf nitride (sometimes referred to TiN, ZrN or HfN respectively in the present invention) or a Ti, Zr or Hf carbonitride (sometimes referred to TiCN, ZrCN or HfCN respectively in the present invention).

In the use of TiN, the nitrogen content is usually 12 to 37 % by mass and the residue is Ti based on 100 % by mass of the total of Ti and nitrogen in the layer. In the use of ZrN, the nitrogen content is usually 74 to 24 % by mass and the residue is Zr based on 100 % by mass of the total of Zr and nitrogen in the layer. In the use of HfN, the nitrogen content is usually 3 to 14 % by mass and the residue is Hf based on 100 % by mass of the total of Hf and nitrogen in the layer.

In the use of TiCN, the nitrogen content is usually 6 to 28 % by mass, the carbon content is usually 5 to 28 % by mass and the residue is Ti based on 100 % by mass of the total of Ti, nitrogen and carbon in the layer. In the use of ZrCN, the nitrogen content is usually 3 to 20 % by mass, the carbon content is usually 3 to 17 % by mass and the residue is Zr based on 100 % by mass of the total of Zr, nitrogen and carbon in the layer. In the use of HfCN, the nitrogen content is usually 1 to 12 % by mass, the carbon content is usually 1 to 10 % by mass and the residue is Hf based on 100 % by mass of the total of Hf, nitrogen and carbon in the layer. The content is determined by X-ray microanalysis.

From the viewpoint of hardness, the primary layer 13 has a thickness of preferably 0.3 to 3.0 µm. The film thickness is measured by the X-ray diffraction method and a stylus type surface roughness tester.

When the primary layer 13 is formed on the substrate 14, the brightness L* is usually 55 to 67, and the surface hardness is usually 1200 to 2100 Hv.

### <Reflecting layer and Finishing layer>

The reflecting layer 12 comprises a metal and the finishing layer 11 comprises Au or an Au alloy. The reflectance of the metal constituting the reflecting layer 12 is higher than that of the metal constituting the finishing layer 11. Forming the reflecting layer under the finishing layer, a decorative part having higher brightness and high-quality golden color tone can be prepared. That is to say, the influence of the color tone of the primary layer 13 formed under the reflecting layer 12 is depressed and thereby a decorative part having a higher brightness and high-quality golden color tone can be prepared.

The reflectance means an average reflectance in the visible light region. The metal constituting the reflecting layer 12 has an average reflectance in the visible region of usually 89 to 93%, and Au or the Au alloy constituting the finishing layer 11 has an average reflectance in the visible light region of usually 83 to 86%. The above average reflectance was determined by installing an integrating sphere on a visible light region spectrophotometer (Hitachi Model: U-3300) followed by measuring.

Examples of the metal having the above average reflectance constituting the reflecting layer 12 may include Ru, Pd, Rh, Ag, Os, Ir and Pt. The above metals may be used singly or two or more may be used in combination. The alloy of the two or more metals also has an average reflectance in the above range.

Examples of the metals having above average reflectance constituting the finishing layer 11 may include pure gold and an Au-Ni alloy, an Au-Cu alloy and an Au-Cu-Pd alloy each having an appropriate composition. More specifically, it is preferred to use an Au-Ni alloy containing 88 to 97 % by mass of Au and 3 to 12 % by mass of Ni (the total of Au and Ni is 100% by mass), an Au-Cu alloy containing 75 to 97 % by mass of Au and 3 to 25 % by mass of Cu (the total of Au and Cu is 100% by mass), and an Au-Cu-Pd alloy containing 71.5 to 89.5 % by mass of Au, 10 to 25 % by mass of Cu and 0.5 to 3.5 % by mass of Pd (the total of Au, Cu and Pd is 100% by mass). Using such Au or Au alloy, a decorative part having high-quality gold color tone and high brightness L* can be prepared.

The reflecting layer 12 has a thickness of preferably 0.001 to 0.02 µm, and the finishing layer 11 has a thickness of preferably 0.001 to 0.85 µm. In a decorative part in which the reflecting layer 12 and the finishing layer 11 each have a thickness in the above range, the high-quality gold color tone having high brightness can be obtained because light transmitted through the finishing layer 11 is reflected on the reflecting layer 12. (When the film thicknesses are in the above ranges, the effect of the reflecting layer 12 having no golden color tone is hardly observed, and high-quality gold color tone having high brightness can be obtained.) Moreover, when the reflecting layer 12 has a thickness in the above range, the finishing layer 11 is flawed and peeled off and thereon the reflecting layer 12 is usually also peeled off together with the finishing layer 11. In this case, since the gold colored primary layer 13 is exposed, there is a merit that flaws do not stand out rather than remaining of the reflecting layer 12 having different color tone. When the reflecting layer 12 has a thickness less than the above range, it sometimes has an inferior effect of reflecting light. On the other hand, when it has a thickness more than the above range, it sometimes has lower hardness and inferior flaw resistance. Furthermore, when the finishing layer 11 is flawed and peeled off, the reflecting layer 12 having different color tone is not peeled off and remained, flaws sometimes are apt to stand out visually. When the finishing layer 11 has a thickness less than the above range, the coating film is formed in an insular state and sometimes has inferior color tone. When the finishing layer 11 has a thickness more than the above range, the hardness is lowered and the flaw resistance is sometimes decreased.

In a resulting decorative part in which the reflecting layer 12 and the finishing layer 11 each have a thickness in the above range, the decorative part has L* of usually 82 to 86, and excellent brightness. The surface hardness thereof is usually 1000 to 1925 Hv and the decorative part has excellent hardness and can maintain flaw resistance.

Additionally, the reflecting layer 12 has a thickness of preferably 0.001 to 0.01 µm, and the finishing layer 11 has a thickness of preferably 0.005 to 0.10 µm. When the thicknesses of the reflecting layer 12 and the finishing layer 11 are in the above ranges, high-quality golden color tone having high brightness can be obtained. Further, the flaw resistance can be maintained to be higher.

When the thicknesses of the reflecting layer 12 and the finishing layer 11 are in the above ranges, the resulting decorative part has L* of usually 83 to 86, a surface hardness of usually 1500 to 1885 Hv and excellent balance between hardness and flaw resistance.

### <Decorative Part>

The decorative parts of the present invention have the above hardening layer and are used for watch bands, watch cases, bezels, back cases, clasps, buckles, crowns, pierced earrings, earrings, rings, glass frames, pendants, brooches, necklaces, bracelets and the like.

### <Production process>

The process for producing a decorative part comprising the substrate and, superimposed on the substrate, the hardening layer obtainable by laminating the primary layer, the reflecting layer and the finishing layer from the substrate side, according to the present invention comprises the steps of:
a primary layer laminating step of laminating the primary layer comprising a nitride, a carbide or a carbonitride of one or two or more metals selected from Ti, Zr and Hf on the substrate,
a reflecting layer laminating step of laminating the reflecting layer comprising a metal on the primary layer, and
a finishing layer laminating step of laminating the finishing layer comprising Au or an Au alloy on the reflecting layer. In the process, the metal constituting the reflecting layer has a higher reflectance than that of the metal constituting the finishing layer.

In the primary layer laminating step, the reflecting layer laminating step and the finishing layer laminating step, the primary layer, reflecting layer and the finishing layer are formed by a dry plating method such as a sputtering method, an ion plating method and an ion beam vapor deposition method.

Examples of the sputtering method may include a RF sputtering method, a DC sputtering method, a DC magnetron sputtering method, a RF magnetron sputtering method. The DC sputtering method has a merit capable of easily controlling the alloy composition.

As the means of generating plasma, it is possible to use any of the RF method and the DC method. The inert gases used for generating plasma are Ar, He, Xe and Kr gases. In the layer forming, the pressure is not limited particularly as far as plasma can be generated.

More specifically, in the primary layer laminating step, the layer having a desired content can be prepared by appropriately controlling an evaporating rate or a sputtering rate of a metal such as Ti, Zr or Hf, a flow rate of a reactive gas such as N₂. or CH₄ and an electric power introducing into gas plasma. Furthermore, the film thickness can be regulated by appropriately changing an evaporating rate or a sputtering rate of a metal such as Ti,' Zr or Hf, a flow rate of a reactive gas such as N₂ or CH₄, an electric power introducing into gas plasma and a time for forming the film.

In the reflecting layer laminating step, the film thickness can be regulated by appropriately changing an evaporating rate or a sputtering rate of a metal having high reflectance, and a time for forming the film.

In the finishing layer laminating step, The layer having a desired content can be prepare by appropriately controlling a composition of a metal used in the finishing layer such as Au or the Au alloy, a rate of evaporation or a rate of sputtering and a time for forming the film. Further, the film thickness can be controlled by appropriately changing a time for forming the film.

For another embodiment, there is mentioned a decorative part prepared by using a substrate 14 previously formed with a metal layer on the substrate. The substrate 14 formed with the metal layer has good adhesion to a primary layer 13.

When the substrate is made from a metal or an alloy except for titanium and a titanium alloy, or ceramics or plastics, the metal layer is preferably made from Hf, Ti or Zr. The metal layer has a thickness of usually 0.02 to 0.2 µm, preferably 0.05 to 0.1 µm.

When the substrate is made from titanium or a titanium alloy, the above-described metal layer may be formed although it is unnecessary to be formed.

The metal layer can be formed by a dry plating method such as a sputtering method, an ion plating method or an arc type ion plating method.

When the substrate is made from a Cu alloy, a metal layer other than the above metal layers may be formed. Examples of such a layer are a metal layer obtainable by forming a nickel coating film having a thickness of 1 to 10 µm, preferably 1 to 5 µm formed on the substrate surface by the wet plating method and forming an amorphous nickel-phosphorus alloy coating film having a thickness of 3 to 10 µm, preferably 3 to 5 µm formed on the nickel coating film surface by the wet plating method, and a 3 layered metal layer obtainable by further forming a titanium coating film in a thickness of 0.02 to 0.2 µm, preferably 0.05 to 0.1 µm on the above alloy coating film surface by the dry plating method. Additionally, from the viewpoint of preventing a nickel allergy, there is mentioned a metal layer obtainable by forming a metal layer which comprises at least one layer of a metal or an alloy selected from the group consisting of copper, palladium, a copper-tin alloy, a copper-tin-zinc alloy and a copper-tin-palladium alloy, in a thickness of 2 to 9 µm, preferably 2 to 3 µm by the wet plating method, and further forming a titanium coating film in a thickness of 0.02 to 0.2 µm, preferably 0.05 to 0.1 µm by the dry plating method.

### [EXAMPLE]

The present invention will be described in more detail with reference to the following examples.

### Example 1

A substrate 14 was disposed in a vacuum device and the vacuum device was evacuated. Thereafter, a TiN layer was formed as a primary layer 13 on the surface of the substrate 14 using Ti with the DC sputtering method in an atmosphere of a Ar and nitrogen mixed gas plasma generated by introducing Ar and nitrogen with keeping a pressure at 0.2 Pa. Furthermore, a reflecting layer 12 was formed on the primary layer 13 using Pt with the DC sputtering method at the same pressure in an atmosphere of the same gas plasma. Moreover, an Au layer was formed on the reflecting layer 12 using Au with the DC sputtering method at the same pressure in an atmosphere of the same gas plasma to form a finishing layer 11. The film formation was carried out by regulating the film forming times so that the TiN layer constituting the primary layer 13 had a film thickness of 0.8 µm, the finishing layer 11 formed from Au had a film thickness of 0.01 µm (10nm) and the total film thickness was 0.81 µm (referred to Table 1). A watch case substrate made from SUS304 having a surface roughness corresponding to the arithmetic average roughness Ra of 200Å finished by polishing with a No. 800 abrasive paper was used as the substrate.

### Examples 2 to 24

In each example, the film formation was carried out in the same manner as described in Example 1 as follows. The vacuum device was evacuated. Thereafter, a HfN, HfCN, TiN, TiCN, ZrN or ZrCN layer was formed as a primary layer 13 on the substrate using Hf, Ti or Zr with the DC sputtering method in an atmosphere of a Ar and nitrogen mixed gas plasma generated by introducing Ar and nitrogen (or an Ar, nitrogen and carbon or hydrocarbon mixed gas plasma generated by introducing Ar, nitrogen and CH₄) with keeping a pressure at 0.2 Pa. Furthermore, a reflecting layer 12 was formed on the primary layer 13 using Ru, Pd, Rh, Ag, Os, Ir or Pt with the DC sputtering method at the same pressure in an atmosphere of the same gas plasma. Moreover, an Au or Au alloy layer was formed on the reflecting layer 12 using Au or an Au alloy with the DC sputtering method at the same pressure in an atmosphere of the same gas plasma to form a finishing layer 11. The film formation was carried out by regulating the film forming times so that the HfN, TiN, TiCN or ZrN layer constituting the primary layer 13 had a film thickness of 0.8 µm, the reflecting layer 12 made from Ru, Pd, Rh, Ag, Os, Ir or Pt had a film thickness of 0.001 µm to 0.01 µm, the Au or Au alloy layer constituting the finishing layer 11 had a film thickness of 0.002 µm to 0.1 µm and the total film thickness was 0.803 µm to 0.910 µm (referred to Table 1).

### Examples 25 to 47

In each example, the film formation was carried out in the same manner as described in Example 1 as follows. The vacuum device was evacuated. Thereafter, a HfN, HfCN, TiN, TiCN, ZrN or ZrCN layer was formed as a primary layer 13 on the substrate using Hf, Ti or Zr with the DC sputtering method in an atmosphere of a Ar and nitrogen mixed gas plasma generated by introducing Ar and nitrogen (or an Ar, nitrogen and carbon or hydrocarbon mixed gas plasma generated by introducing Ar, nitrogen and CH₄) with keeping a pressure at 0.2 Pa. Furthermore, a reflecting layer 12 was formed on the primary layer 13 using Ru, Pd, Rh, Ag, Os, Ir or Pt with the DC sputtering method at the same pressure in an atmosphere of the same gas plasma. Moreover, an Au or Au alloy layer was formed on the reflecting layer 12 using Au or an Au alloy with the DC sputtering method at the same pressure in an atmosphere of the same gas plasma to form a finishing layer 11. The film formation was carried out by regulating the film forming times so that the reflecting layer and the finishing layer each had an arbitrary thickness and the total film thickness was 0.8 µm to 1.65 µm (referred to Table 3).

### Comparative Examples 1 to 22

In each of Comparative examples 1 to 22, on the surface of a watch case, watch band, watch bezel, back case or clasp substrate which is a decorative part substrate made from Ti, a Ti alloy, SUS304 or SUS316L, a TiN, ZrN, TiCN, HfCN, ZrCN or HfN layer was formed as a primary layer and a finishing layer having a thickness of 0.81 to 0.91 µm was formed by using Au or an Au alloy having an arbitrary composition and regulating the time with the DC sputtering method, but a reflecting layer was not formed (referred to Table 5).

On the decorative parts prepared in Examples 1 to 47 and Comparative Examples 1 to 22, a hardness test and a colorimetry evaluating test were carried out. The results and the overall evaluation results are shown in Tables 1 to 6. The other measuring results are also shown in Tables 7-1 to 8-2.

### <Evaluation methods>

### (Primary layer)

The composition of the primary layer such as the HfN layer TiN layer or ZrN layer was determined by EPMA analysis (X-ray micro analysis). EPMA is a measuring apparatus such that elements contained in an object are identified from a wavelength and an intensity of fluorescent X-ray generated by irradiating an electron ray to the object, and elements having an atomic weight larger than that of B (boron) can be detected. In the composition analysis method according to the present invention, on the surface of a Si wafer substrate, a monolayer film such as HfN, TiN, ZrN, HfCN, TiCN or ZrCN was formed in a thickness of about 0.3 µm with the.DC reactive sputtering method to form a measuring specimen, and the specimen was measured and analyzed by a JXA-8200 model EPMA (manufactured by JEOL Ltd.) at an accelerating voltage of 15 kV at a probe current of 50 nA.

The composition of TiN in Example 1 was determined as follows. At first, a primary layer was formed in the same conditions as described in Example 1 except that a Si wafer was used as a substrate, the film forming time was shortened and the thickness of the primary layer was 0.3 µm. Next, this specimen was submitted to the above EPMA measurement and the composition of TiN was determined. Since this value was the same' value as the composition of TiN in Example 1, it was taken as the composition of TiN of Example 1. In Examples 2 to 47, the composition of the primary layer was determined in the same manner as described in Example 1.

The film thickness of the primary layer was determined by an X-ray diffraction method and a stylus type surface roughness tester. In the present invention, the film thickness of the primary layer was determined in the following manner. On the Si wafer substrate,' a monolayer film such as HfN, TiN, ZrN, HfCN, TiCN or ZrCN was formed with mask film forming by the DC reactive sputtering method, and the thickness of the film formed was measured using Smart Labo (manufactured by JEOL Ltd.) as the X-ray diffraction apparatus from a Cu-Kα ray by a thin film diffraction method. When the diffraction patterns overlapped, wave separation was carried out to determine an angle of diffraction. A difference in level of the mask part in the film formed was measured by Alpha step IQ (manufactured by Tencor Co.) as the stylus type surface roughness tester in such conditions that the needle tip diameter was 12. 5 µm, the needle pressure was 10 mg in weight and the scanning rate was 50 µm/sec. The film thickness was determined by averaging the value determined with the thin film diffraction method and the value determined with the stylus type surface roughness tester.

In Example 1, the film thickness of the primary layer was determined concretely in the following manner. At first, the primary layer was partly formed in the conditions as described in Example 1 except for using a Si wafer as the substrate and using a mask. Next, the film formed part of this specimen was submitted to the above X-ray diffraction measurement and thereby the film thickness was determined. Furthermore, a difference in level (film thickness) of the film formed part was determined by the above stylus type surface roughness tester. The film thickness was determined by averaging the both values. Since this value was the same value as the film thickness of the primary layer of Example 1, this value was taken as the film thickness of the primary layer of Example 1. In Examples 2 to 47, the film thickness of the primary layer was determined in the same manner as described in Example 1.

The hardness of the primary layer was measured under a load of 5 mN by a micro Vickers hardness meter.

In the micro Vickers hardness of the primary layer, the primary layer film formed on the Si wafer substrate was used as an object to be measured. The micro Vickers hardness was determined by a hardness meter (H100VP-HCU manufactured by Fisher Instruments Co.) from the depth of a dent and a hysteresis between indentation and indentation recovery in the following conditions.

Indenter: based on ISO 14577, a diamond quadrangular pyramid having an interfacial angle of 136°
Force of Indentation: 5 mN
In this test, the indentation hardness HIV was obtained, and it was converted to the Vickers hardness HV in accordance with ISO-14577-1. The measurement was carried out at 5 points on the surface of the specimen and the average thereof was adopted.

The micro Vickers hardness of the primary layer in Example 1 was determined concretely in the following manner. At first, the primary layer was formed in the same conditions as described in Example 1 except for using a Si wafer as the substrate. Next, this specimen was submitted to the above measurement and thereby the micro Vickers hardness was determined. This value was taken as the hardness of the primary layer in Example 1. In Examples 2 to 47, the hardness of the primary layer was determined in the same manner as described in Example 1.

The brightness of the primary layer was determined using a spectrophotometer (CM-2600d manufactured by Konica Minolta Co.). The light source used was D₆₅ defined in JIS Z 8720 and the view angle was 10° in the measurement.

The brightness of the primary layer in Example 1 was determined concretely in the following manner. At first, the primary layer was formed in the same conditions as described in Example 1 except for using a Si wafer as the substrate. Next, this specimen was submitted to the above measurement and thereby the brightness was determined. This value was taken as the brightness of the primary layer in Example 1. In Examples 2 to 47, the brightness of the primary layer was also determined in the same manner as described in Example 1.

### (Reflecting layer)

The average reflectance of the metal constituting the reflecting layer was measured by installing an integrating sphere to a visible light band spectrophotometer (Model: U-3300 Hitachi Ltd.). In one optical system of the spectrophotometer, the integrating sphere was set and a wedge shaped sample hold jig having a vertical angle of 10° with a 20 0̸ hole was installed at the position where the specimen was to be placed. The jig was used in order that in the measurement, reflected light from the specimen can be bound by the inside of the integrating sphere without leaking into the incident light side. In the wedge shaped sample hold jig for measurement thus prepared, a standard white plate (barium sulfate white plate) recommended by CIE is installed, light having wave lengths in the visible light region was irradiated, and the intensity of the reflected light was taken in each wave length and the value was recorded as 100% reflectance. Practically, the data was memorized in the memory of a computer. Successively, the specimen prepared by forming the film of the metal constituting the reflecting layer on the Si wafer plane substrate was installed in the wedge shaped sample hold jig and light having a wavelength in the visible light region was irradiated. The intensity of the reflected light was taken in each wavelength and thereby the reflectance of the specimen was determined based on 100% of the reflectance of the standard white plate in each wavelength. Substantially, since the reflectance of the standard white plate was not 100%, and it was definite to about 96% in the visible light region, the accurate reflectance of the specimen in certain wavelength was determined by dividing the reflectance of the specimen in its wavelength by 0.96.

The average reflectance described in the specification means a value determined by obtaining the spectral reflectance per wavelength in the visible light region (380 nm to 780 nm) in the above method and averaging them without weighing.

The average reflectance of Pt used in Example 1 was determined in the following manner. At first, on a Si wafer substrate, a Pt layer having a thickness of 0.3 µm was formed. Next, the specimen was submitted to the above measurement and thereby the average reflectance was determined. This value was taken as the average reflectance of Pt. In Examples 2 to 47, the average reflectance of the metal used was determined in the same manner as described above.

The film thickness of the reflecting layer was determined by the X-ray diffraction method and the stylus type surface roughness tester. The specimen for measurement of the film thickness was prepared by forming the primary layer on the overall surface of the Si wafer plane substrate, and partly forming the reflecting film with mask film forming. The film thickness of the film-formed part was measured using Smart Labo (manufactured by JEOL Ltd.) as the X-ray diffraction apparatus by a Cu-Kα ray with a thin film diffraction method. When the diffraction patterns overlapped, wave separation was carried out to determine an angle of diffraction. A difference in level of the mask part in the film formed was measured by Alpha step IQ (manufactured by Tencor Co.) as the stylus type surface roughness tester in such conditions that the needle tip diameter was 12.5 µm, the needle pressure was 10 mg in weight and the scanning rate was 50 µm/sec. The film thickness was determined by averaging the value determined with the thin film diffraction method and the value determined with the stylus type surface roughness tester.

In Example 1, the film thickness of the reflecting layer was determined concretely in the following manner. At first, the primary layer was formed in the conditions as described in Example 1 except for using a Si wafer as the substrate. Next, the reflecting layer was partly formed in the same conditions as described in Example 1 except for using a mask. The film formed part of this specimen was submitted to the above X-ray diffraction measurement and thereby the film thickness was determined. Furthermore, a difference in level (film thickness) of the film formed part was determined by the above stylus type surface roughness tester. The film thickness was determined by averaging the both values. Since this value was the same value as the film thickness of the reflecting layer of Example 1, this value was taken as the film thickness of the reflecting layer of Example 1. In Examples 2 to 47, the film thickness of the reflecting layer was determined in the same manner as described in Example 1.

### (Finishing layer)

The average reflectance of the metal constituting the finishing layer was measured by installing an integrating sphere to the visible light region spectrophotometer (Model: U-3300 manufactured by Hitachi Co.) in the same manner as described in the measurement of the average reflectance of the reflecting layer.

In Example 1, the average reflectance of Au was determined concretely in the following manner. At first, on a Si wafer plane substrate, the Au layer having a thickness of 0.3 µm was formed. Next, using the specimen for measurement, the average reflectance was determined by the same measurement and calculation as those of the average reflectance of the above reflecting layer. This value was taken as the average reflectance of Au. In Examples 2 to 47, the average reflectance of Au or the Au alloy was determined in the same manner as above.

The composition of the finishing layer formed by the Au alloy layer was determined by EPMA analysis (X-ray microanalysis). Regarding the composition of the finishing layer, a specimen having the same finishing layer as used in the average reflectance measurement of the metal constituting the finishing layer was measured and analyzed by Model JXA-8200 EPMA (manufactured by JEOL Ltd.) at an accelerating voltage of 15 kV and a prove electric current of 50 nA.

In Example 2, the composition of the Au alloy was determined concretely in the following manner. At first, the primary layer, the reflecting layer and the finishing layer were formed in the same conditions as described in Example 2 except that a Si wafer was used as the substrate and the thickness of the finishing layer was 0. 3 µm by regulating the film forming time. Next, the specimen thus prepared was submitted to the above EPMA measurement and thereby the composition of the Au alloy was determined. Since this value was the same as the composition of the Au alloy in Example 2, this value was taken as the composition of the Au alloy in Example 2. In Examples 3 to 47, the composition of the finishing layer was determined in the same manner as in Example 2.

The film thickness of the finishing layer was determined by the X-ray diffraction method and the stylus type surface roughness tester. The specimen for film thickness measurement was prepared by forming the primary layer and the reflecting layer on the overall surface of the Si wafer plane substrate, and partly forming the finishing layer with mask film forming. The film thickness of the film-formed part using Smart Labo (manufactured by JEOL Ltd.) as the X-ray diffraction apparatus by a Cu-Kα ray with the thin film diffraction method. When the diffraction patterns overlapped, wave separation was carried out to determine an angle of diffraction. A difference in level of the mask part in the film formed was measured by Alpha step IQ (manufactured by Tencor Co.) as the stylus type surface roughness tester in such conditions that the needle tip diameter was 12.5 µm, the needle pressure was 10 mg in weight and the scanning rate was 50 µm/sec. The film thickness was determined by averaging the value determined by the thin film diffraction method and the value determined by the stylus type surface roughness tester.

In Example 1, the film thickness of the finishing layer was determined concretely in the following manner. At first, on the Si wafer substrate, the primary layer and reflecting layer were formed in the conditions as described in Example 1. Next, the finishing layer was partly formed in the same conditions as described in Example 1 except for using a mask. The film formed part of this specimen was submitted to the above X-ray diffraction measurement and thereby the film thickness was determined. Furthermore, a difference in level (film thickness) of the film formed part was determined by the above stylus type surface roughness tester. The film thickness was determined by averaging the both values. Since this value was the same value as the film thickness of the finishing layer of Example 1, this value was taken as the film thickness of the finishing layer of Example 1. In Examples 2 to 47, the film thickness of the finishing layer was determined in the same manner as described in Example 1.

### (Decorative part)

The hardness of the decorative part was measured at a load of 5 mN by the micro Vickers hardness tester. When the Vickers hardness Hv was less than 1000, it was represented by X, when it was not less 1000 and less than 1500, it was represented by ○, and when it was not less than 1500, it was acceptable and represented by ⊚.

In the measurement for the micro Vickers hardness of the decorative part of the present invention, a decorative part prepared by laminating the primary layer, the reflecting layer and the finishing layer in this order on a SUS316L plane substrate having one mirror polished surface was used. The micro Vickers hardness was determined by a hardness meter (H100VP-HCU manufactured by Fisher Instruments Co.) from the depth of a dent and a hysteresis between indentation and indentation recovery in the following conditions.

Indenter: based on ISO 14577, a diamond quadrangular pyramid having an interfacial angle of 136°
Force of Indentation: 5 mN
In this test, the indentation hardness HIV was obtained, and it was converted to the Vickers hardness HV in accordance with ISO-14577-1. The measurement was carried out at 5 points on the surface of the specimen and the average thereof was adopted.

The micro Vickers hardness of the decorative part in Example 1 was determined concretely in the following manner. At first, the specimen was prepared by forming the primary layer, the reflecting layer and the finishing layer in the same conditions as described in Example 1 except for using a SUS316L as the substrate. Next, this specimen was submitted to the above measurement and thereby the micro Vickers hardness was determined. This value was taken as the hardness of the decorative part in Example 1. In Examples 2 to 47, the hardness of the decorative part was determined in the same manner as described in Example 1.

The color tone of the decorative part was evaluated using a spectrophotometer (CM-2600d manufactured by Konica Minolta Co.). The light source used was D₆₅ defined in JIS Z 8720 and the view angle was 10° in the measurement. In the chromaticity diagram of L*a*b* color specification system defined in JIS Z 8729, when L* was not less than 83, the color tone was acceptable and represented by ⊚, when L* is not less than 82 and less than 83, the color tone was also acceptable and represented by ○ and when L* was less than 82, the color tone was not acceptable and represented by ×.

The brightness of the decorative part in Example 1 was determined concretely in the following manner. At first, the specimen was prepared by forming the primary layer, the reflecting layer and the finishing layer in the same conditions as described in Example 1 except for using the SUS316L substrate. Next, this specimen was submitted to the above measurement and thereby the brightness was determined. This value was taken as the brightness of the decorative part in Example 1. In Examples 2 to 47, the brightness of the decorative part was also determined in the same manner as described in Examples 1.

The decorative part which was acceptable in the hardness test and the colorimetry evaluating test was acceptable in the overall evaluation.

**Table 1**

| Ex. | Decorative part | Substrate | Primary layer | | Reflecting layer | | Composition of Finishing layer (wt%) | | | | Film thickness of Fishing layer(µm) |
|---|---|---|---|---|---|---|---|---|---|---|---|
| | | | Constitution Material | Film thickness (µm) | Constitution Material | Film thickness (µm) | Au | Cu | Pd | Ni | |
| 1 | Watch case | SUS304 | TiN | 0.80 | Pt | 0.0010 | 100 | - | - | - | 0.010 |
| 2 | Watch band | Ti | TiCN | 0.80 | Pt | 0.0010 | 85.0 | 14.0 | 1.0 | - | 0.080 |
| 3 | Watch case | SUS316 | ZrN | 0.80 | Ag | 0.0010 | 75.2 | 23.3 | 1.5 | - | 0.080 |
| 4 | Watch band | SUS304 | HfN | 0.80 | Os | 0.0010 | 95.0 | - | - | 5.0 | 0.070 |
| 5 | Watch case | Ti alloy | ZrCN | 0.80 | Pd | 0.0010 | 100 | - | - | - | 0.090 |
| 6 | Watch bezel | SUS316L | HfN | 0.80 | Pd | 0.0010 | 85.0 | 14.0 | 1.0 | - | 0.050 |
| 7 | Watch case | Ti | TiN | 0.80 | Pt | 0.0025 | 75.2 | 23.3 | 1.5 | - | 0.100 |
| 8 | Back case | SUS316L | TiN | 0.80 | Pt | 0.0025 | 95.0 | - | - | 5.0 | 0.010 |
| 9 | Back case | Ti alloy | TiCN | 0.80 | Ag | 0.0025 | 100 | - | - | - | 0.002 |
| 10 | Clasp | SUS316L | TiN | 0.80 | Ag | 0.0025 | 85.0 | 14.0 | 1.0 | - | 0.080 |
| 11 | Clasp | SUS316 | HfN | 0.80 | Pd | 0.0025 | 75.2 | 23.3 | 1.5 | - | 0.070 |
| 12 | Watch case | Ti | HfCN | 0.80 | Ir | 0.0025 | 95.0 | - | - | 5.0 | 0.040 |
| 13 | Watch case | SUS304 | ZrN | 0.80 | Pt | 0.0050 | 100 | - | - | - | 0.050 |
| 14 | Watch case | Ti alloy | TiN | 0.80 | Pt | 0.0050 | 85.0 | 14.0 | 1.0 | - | 0.020 |
| 15 | Watch case | SUS316L | TiN | 0.80 | Ag | 0.0050 | 75.2 | 23.3 | 1.5 | - | 0.010 |
| 16 | Watch band | Ti | TiCN | 0.80 | Os | 0.0050 | 95.0 | - | - | 5.0 | 0.020 |
| 17 | Clasp | SUS316 | TiN | 0.80 | Pd | 0.0050 | 100 | - | - | - | 0.080 |
| 18 | Watch band | SUS304 | TiCN | 0.80 | Ru | 0.0050 | 85.0 | 14.0 | 1.0 | - | 0.030 |
| 19 | Watch band | SUS316L | TiN | 0.80 | Pt | 0.0100 | 75.2 | 23.3 | 1.5 | - | 0.030 |
| 20 | Watch bezel | Ti | HfCN | 0.80 | Rh | 0.0100 | 95.0 | - | - | 5.0 | 0.050 |
| 21 | Watch bezel | Ti alloy | ZrN | 0.80 | Ag | 0.0100 | 100 | - | - | - | 0.005 |
| 22 | Watch bezel | SUS316 | HfN | 0.80 | Os | 0.0100 | 85.0 | 14.0 | 1.0 | - | 0.080 |
| 23 | Watch bezel | SUS316L | ZrCN | 0.80 | Pd | 0.0100 | 75.2 | 23.3 | 1.5 | - | 0.007 |
| 24 | Back case | SUS304 | ZrN | 0.80 | Ir | 0.0100 | 95.0 | - | - | 5.0 | 0.040 |

**Table 2**

| Ex. | Hardness test | | Colorimetry evaluating test | | Overall Evaluation |
|---|---|---|---|---|---|
| | Vickers hardness (Hv) | Evaluation on Hardness | Value L* in Spectro-photometric colorimeter | Evaluation on Colorimetry | |
| 1 | 1800 | ⊚ | 83.5 | ⊚ | Acceptance |
| 2 | 1505 | ⊚ | 83.8 | ⊚ | Acceptance |
| 3 | 1580 | ⊚ | 83.9 | ⊚ | Acceptance |
| 4 | 1650 | ⊚ | 83.7 | ⊚ | Acceptance |
| 5 | 1510 | ⊚ | 83.8 | ⊚ | Acceptance |
| 6 | 1600 | ⊚ | 85.2 | ⊚ | Acceptance |
| 7 | 1500 | ⊚ | 84.1 | ⊚ | Acceptance |
| 8 | 1820 | ⊚ | 83.8 | ⊚ | Acceptance |
| 9 | 1860 | ⊚ | 83.6 | ⊚ | Acceptance |
| 10 | 1575 | ⊚ | 84.5 | ⊚ | Acceptance |
| 11 | 1555 | ⊚ | 84.6 | ⊚ | Acceptance |
| 12 | 1600 | ⊚ | 84.0 | ⊚ | Acceptance |
| 13 | 1650 | ⊚ | 83.5 | ⊚ | Acceptance |
| 14 | 1660 | ⊚ | 84.0 | ⊚ | Acceptance |
| 15 | 1820 | ⊚ | 83.7 | ⊚ | Acceptance |
| 16 | 1800 | ⊚ | 84.0 | ⊚ | Acceptance |
| 17 | 1505 | ⊚ | 84.2 | ⊚ | Acceptance |
| 18 | 1835 | ⊚ | 84.0 | ⊚ | Acceptance |
| 19 | 1735 | ⊚ | 84.0 | ⊚ | Acceptance |
| 20 | 1605 | ⊚ | 84.3 | ⊚ | Acceptance |
| 21 | 1885 | ⊚ | 83.5 | ⊚ | Acceptance |
| 22 | 1540 | ⊚ | 84.6 | ⊚ | Acceptance |
| 23 | 1840 | ⊚ | 83.5 | ⊚ | Acceptance |
| 24 | 1585 | ⊚ | 84.4 | ⊚ | Acceptance |

**Table 3**

| Ex. | Decorative part | Substrate | Primary layer | | Reflecting layer | | Composition of Finishing layer (wt%) | | | | Film thickness of Fishing layer(µm) |
|---|---|---|---|---|---|---|---|---|---|---|---|
| | | | Constitution Material | Film thickness (µm) | Constitution Material | Film thickness (µm) | Au | Cu | Pd | Ni | |
| 25 | Watch case | SUS304 | TiN | 0.80 | Pt | 0.0010 | 100 | - | - | - | 0.030 |
| 26 | Watch band | Ti | TiCN | 0.80 | Pt | 0.0010 | 85.0 | 14.0 | 1.0 | - | 0.040 |
| 27 | Watch case | SUS316 | ZrN | 0.80 | Ag | 0.0010 | 75.2 | 23.3 | 1.5 | - | 0.060 |
| 28 | Watch band | SUS304 | HfN | 0.80 | Os | 0.0010 | 95.0 | - | - | 5.0 | 0.850 |
| 29 | Watch case | Ti | TiN | 0.80 | Pt | 0.0025 | 75.2 | 23.3 | 1.5 | - | 0.350 |
| 30 | Back case | SUS316L | TiN | 0.80 | Pt | 0.0025 | 95.0 | - | - | 5.0 | 0.450 |
| 31 | Back case | Ti alloy | TiCN | 0.80 | Ag | 0.0025 | 100 | - | - | - | 0.600 |
| 32 | Clasp | SUS316L | TiN | 0.80 | Ag | 0.0025 | 85.0 | 14.0 | 1.0 | - | 0.850 |
| 33 | Watch case | SUS304 | ZrN | 0.80 | Pt | 0.0050 | 100 | - | - | - | 0.350 |
| 34 | Watch case | Ti alloy | TiN | 0.80 | Pt | 0.0050 | 85.0 | 14.0 | 1.0 | - | 0.450 |
| 35 | Watch case | SUS316L | TiN | 0.80 | Ag | 0.0050 | 75.2 | 23.3 | 1.5 | - | 0.600 |
| 36 | Watch band | Ti | TiCN | 0.80 | Os | 0.0050 | 95.0 | - | - | 5.0 | 0.850 |
| 37 | Watch band | SUS316L | TiN | 0.80 | Pt | 0.0100 | 75.2 | 23.3 | 1.5 | - | 0.350 |
| 38 | Watch bezel | Ti | HfCN | 0.80 | Rh | 0.0100 | 95.0 | - | - | 5.0 | 0.450 |
| 39 | Watch bezel | Ti alloy | ZrN | 0.80 | Ag | 0.0100 | 100 | - | - | - | 0.600 |
| 40 | Watch bezel | SUS316 | HfN | 0.80 | Os | 0.0100 | 85.0 | 14.0 | 1.0 | - | 0.850 |
| 41 | Watch case | SUS304 | ZrN | 0.80 | Pd | 0.0200 | 100 | - | - | - | 0.060 |
| 42 | Back case | Ti | HfN | 0.80 | Pt | 0.0200 | 85.0 | 14.0 | 1.0 | - | 0.040 |
| 43 | Watch case | Ti alloy | ZrCN | 0.80 | Pd | 0.0010 | 100 | - | - | - | 0.001 |
| 44 | Clasp | SUS316 | HfN | 0.80 | Pd | 0.0025 | 75.2 | 23.3 | 1.5 | - | 0.001 |
| 45 | Clasp | SUS316 | TiN | 0.80 | Pd | 0.0050 | 100 | - | - | - | 0.001 |
| 46 | Watch bezel | SUS316L | ZrCN | 0.80 | Pd | 0.0100 | 75.2 | 23.3 | 1.5 | - | 0.001 |
| 47 | Back case | SUS316 | ZrN | 0.80 | Pt | 0.0200 | 75.2 | 23.3 | 1.5 | - | 0.001 |

**Table 4**

| Ex. | Hardness test | | Colorimetry evaluating test | | Overall Evaluation |
|---|---|---|---|---|---|
| | Vickers hardness (Hv) | Evaluation on Hardness | Value L* in Spectro-photometric colorimeter | Evaluation on Colorimetry | |
| 25 | 1830 | ⊚ | 84.5 | ⊚ | Acceptance |
| 26 | 1515 | ⊚ | 84.7 | ⊚ | Acceptance |
| 27 | 1550 | ⊚ | 83.5 | ⊚ | Acceptance |
| 28 | 1160 | ○ | 83.5 | ⊚ | Acceptance |
| 29 | 1265 | ○ | 85.1 | ⊚ | Acceptance |
| 30 | 1095 | ○ | 84.5 | ⊚ | Acceptance |
| 31 | 1130 | ○ | 84.0 | ⊚ | Acceptance |
| 32 | 1200 | ○ | 83.5 | ⊚ | Acceptance |
| 33 | 1285 | ○ | 85.1 | ⊚ | Acceptance |
| 34 | 1250 | ○ | 84.5 | ⊚ | Acceptance |
| 35 | 1205 | ○ | 84.0 | ⊚ | Acceptance |
| 36 | 1050 | ○ | 83.5 | ⊚ | Acceptance |
| 37 | 1290 | ○ | 85.1 | ⊚ | Acceptance |
| 38 | 1275 | ○ | 84.5 | ⊚ | Acceptance |
| 39 | 1260 | ○ | 84.0 | ⊚ | Acceptance |
| 40 | 1280 | ○ | 83.5 | ⊚ | Acceptance |
| 41 | 1250 | ○ | 85.9 | ⊚ | Acceptance |
| 42 | 1325 | ○ | 86.0 | ⊚ | Acceptance |
| 43 | 1925 | ⊚ | 82.4 | ○ | Acceptance |
| 44 | 1825 | ⊚ | 82.2 | ○ | Acceptance |
| 45 | 1790 | ⊚ | 82.2 | ○ | Acceptance |
| 46 | 1900 | ⊚ | 82.5 | ○ | Acceptance |
| 47 | 1750 | ⊚ | 82.2 | ○ | Acceptance |

**Table 5**

| Compar. Ex. | Decorative part | Substrate | Primary layer | | Composition of Finishing layer (wt%) | | | | | | Film thickness of Fishing layer (µm) |
|---|---|---|---|---|---|---|---|---|---|---|---|
| | | | Constitution Material | Film thickness (µm) | Au | Cu | Pt | Pd | Ag | In | |
| 1 | Watch case | SUS304 | TiN | 0.80 | 76.5 | 3.4 | 10.0 | 7.3 | 1.8 | 1.0 | 0.010 |
| 2 | Watch band | Ti | TiCN | 0.80 | 74.3 | 3.6 | 13.0 | 6.8 | 1.3 | 1.0 | 0.020 |
| 3 | Watch case | SUS316 | ZrN | 0.80 | 86.2 | 3.5 | - | 7.5 | 1.8 | 1.0 | 0.080 |
| 4 | Watch band | SUS304 | HfN | 0.80 | 75.7 | 3.6 | 9.5 | 9.2 | 2.0 | - | 0.070 |
| 5 | Watch case | Ti alloy | ZrCN | 0.80 | 76.5 | 3.4 | 10.0 | 7.3 | 1.8 | 1.0 | 0.030 |
| 6 | Watch bezel | SUS316L | HfN | 0.80 | 74.3 | 3.6 | 13.0 | 6.8 | 1.3 | 1.0 | 0.050 |
| 7 | Watch case | Ti | TiN | 0.80 | 86.2. | 3.5 | - | 7.5 | 1.8 | 1.0 | 0.010 |
| 8 | Back case | SUS316L | TiN | 0.80 | 75.7 | 3.6 | 9.5 | 9.2 | 2.0 | - | 0.010 |
| 9 | Back case | Ti alloy | TiCN | 0.80 | 76.5 | 3.4 | 10.0 | 7.3 | 1.8 | 1.0 | 0.030 |
| 10 | Clasp | SUS316L | TiN | 0.80 | 74.3 | 3.6 | 13.0 | 6.8 | 1.3 | 1.0 | 0.080 |
| 11 | Watch bezel | SUS316L | zrCN | 0.80 | 86.2 | 3.5 | - | 7.5 | 1.8 | 1.0 | 0.070 |
| 12 | Back case | SUS304 | ZrN | 0.80 | 75.7 | 3.6 | 9.5 | 9.2 | 2.0 | - | 0.040 |
| 13 | Watch case | SUS304 | TiN | 0.80 | 100 | - | - | - | - | - | 0.010 |
| 14 | Watch band | Ti | TiCN | 0.80 | 85.0 | 14.0 | 1.0 | - | - | - | 0.080 |
| 15 | Watch case | SUS316 | ZrN | 0.80 | 75.2 | 23.3 | 1.5 | - | - | - | 0.080 |
| 16 | Watch band | SUS304 | HfN | 0.80 | 95.0 | - | - | 5 | - | - | 0.070 |
| 17 | Watch case | Ti alloy | ZrCN | 0.80 | 100 | - | - | - | - | - | 0.090 |
| 18 | Watch bezel | SUS306L | HfN | 0.80 | 85.0 | 14.0 | 1.0 | - | - | - | 0.050 |
| 19 | Watch case | Ti | TiN | 0.80 | 75.2 | 23.3 | 1.5 | - | - | - | 0.100 |
| 20 | Back case | SUS316L | TiN | 0.80 | 95.0 | - | - | 5 | - | - | 0.010 |
| 21 | Back case | Ti alloy | TiCN | 0.80 | 100 | - | - | - | - | - | 0.002 |
| 22 | Clasp | SUS316L | TiN | 0.80 | 85.0 | 14.0 | 1.0 | - | - | - | 0.080 |

**Table 6**

| Compar. Ex. | Hardness test | | Colorimetry evaluating test | | Overall Evaluation |
|---|---|---|---|---|---|
| | | | Value in Spectro-photometric colorimeter | | |
| | Vickers hardness (Hv) | Evaluation on Hardness | L* | Evaluation on Colorimetry | |
| 1 | 1830 | ⊚ | 75.6 | x | Failure |
| 2 | 1790 | ⊚ | 76.8 | x | Failure |
| 3 | 1770 | ⊚ | 80.6 | x | Failure |
| 4 | 1810 | ⊚ | 80.0 | x | Failure |
| 5 | 1860 | ⊚ | 76.9 | x | Failure |
| 6 | 1690 | ⊚ | 79.7 | x | Failure |
| 7 | 1840 | ⊚ | 75.2 | x | Failure |
| 8 | 1540 | ⊚ | 74.2 | x | Failure |
| 9 | 1980 | ⊚ | 76.88 | x | Failure |
| 10 | 1760 | ⊚ | 80.1 | x | Failure |
| 11 | 1950 | ⊚ | 80.5 | x | Failure |
| 12 | 1890 | ⊚ | 79.8 | x | Failure |
| 13 | 1830 | ⊚ | 80.5 | x | Failure |
| 14 | 1515 | ⊚ | 81.4 | x | Failure |
| 15 | 1550 | ⊚ | 81.2 | x | Failure |
| 16 | 1590 | ⊚ | 81.3 | x | Failure |
| 17 | 1560 | ⊚ | 81.2 | x | Failure |
| 18 | 1580 | ⊚ | 81.4 | x | Failure |
| 19 | 1510 | ⊚ | 81.2 | x | Failure |
| 20 | 1840 | ⊚ | 81.4 | x | Failure |
| 21 | 1820 | ⊚ | 79.5 | x | Failure |
| 22 | 1605 | ⊚ | 81.3 | x | Failure |

**Table 7-1**

| Ex. | Primary layer | | | Reflecting layer | Finishing layer |
|---|---|---|---|---|---|
| | Content (wt%) | Vickers hardness (Hv) | L* | Average reflectance (%) | Average reflectance (%) |
| 1 | Ti(79) N(21) | 1960 | 65 | Pt(93) | 86 |
| 2 | Ti(75) C(10) N (15) | 1700 | 62 | Pt(93) | 84 |
| 3 | Zr(89) N(11) | 1720 | 64 | Ag(92) | 83 |
| 4 | Hf(94) N(6) | 1780 | 66 | Os(92) | 85 |
| 5 | Zr(84) C(7) N(9) | 1680 | 60 | Pd(90) | 86 |
| 6 | Hf(94) N(6) | 1780 | 66 | Pd(90) | 84 |
| 7 | Ti (83) N(17) | 1680 | 65 | Pt(93) | 83 |
| 8 | Ti(79) N(21) | 1960 | 65 | Pt(93) | 85 |
| 9 | Ti(68) C(14) N(18) | 2000 | 61 | Ag(92) | 86 |
| 10 | Ti(83) N(17) | 1690 | 62 | Ag(92) | 84 |
| 11 | Hf(95) N (5) | 1710 | 65 | Pd(90) | 83 |
| 12 | Hf(92) C(3) N(5) | 1700 | 64 | Ir(90) | 85 |

**Table 7-2**

| Ex. | Primary layer | | | Reflecting layer | Finishing layer |
|---|---|---|---|---|---|
| | Content (wt%) | Vickers hardness (Hv) | L* | Average reflectance (%) | Average reflectance (%) |
| 13 | Zr(88) N(12) | 1780 | 63 | Pt(93) | 86 |
| 14 | Ti(80) N(20) | 1780 | 64 | Pt(93) | 85 |
| 15 | Ti(79) N(21) | 2000 | 63 | Ag(93) | 83 |
| 16 | Ti(71) C(13) N(16) | 1900 | 61 | Os(93) | 85 |
| 17 | Ti(82) N(18) | 1700 | 64 | Pd(90) | 86 |
| 18 | Ti(69) C(14) N(17) | 2000 | 60 | Ru(90) | 85 |
| 19 | Ti(80) N(20) | 1860 | 65 | Pt(93) | 83 |
| 20 | Hf(91) C(4) N(5) | 1800 | 64 | Rh(90) | 85 |
| 21 | Zr(87) N(13) | 2060 | 62 | Ag(92) | 86 |
| 22 | Hf(95) N(5) | 1700 | 66 | Os(92) | 84 |
| 23 | Zr(80) C(9) N(11) | 2040 | 59 | Pd(90) | 83 |
| 24 | Zr(88) N(12) | 1800 | 62 | Ir(90) | 85 |

**Table 8-1**

| Ex. | Primary layer | | | Reflecting layer | Finishing layer |
|---|---|---|---|---|---|
| | Content (wt%) | Vickers hardness (Hv) | L* | Average reflectance (%) | Average reflectance (%) |
| 25 | Ti(79) N(21) | 2060 | 64 | Pt(93) | 86 |
| 26 | Ti(73) C(12) N(15) | 1760 | 62 | Pt(93) | 84 |
| 27 | Zr(89) N(11) | 1700 | 63 | Ag(92) | 83 |
| 28 | Hf(97) N(3) | 1350 | 67 | Os(92) | 85 |
| 29 | Ti(85) N(15) | 1400 | 65 | Pt(93) | 83 |
| 30 | Ti(85) N(15) | 1310 | 65 | Pt(93) | 85 |
| 31 | Ti(79)C(8) N(13) | 1400 | 63 | Ag(92) | 86 |
| 32 | Ti(85) N(15) | 1420 | 66 | Ag(92) | 84 |
| 33 | Zr(91) N(9) | 1420 | 67 | Pt(93) | 86 |
| 34 | Ti(85) N(15) | 1420 | 66 | Pt(93) | 84 |
| 35 | Ti(85) N(15) | 1420 | 66 | Ag(92) | 83 |
| 36 | Ti(84) C(7) N(9) | 1280 | 64 | Os(92) | 85 |

**Table 8-2**

| Ex. | Primary layer | | | Reflecting layer | Finishing layer |
|---|---|---|---|---|---|
| | Content (wt%). | Vickers hardness (Hv) | L* | Average reflectance (%) | Average reflectance (%) |
| 37 | Ti(85) N(15) | 1450 | 65 | Pt(93) | 83 |
| 38 | Hf(95) C(2) N(3) | 1480 | 64 | Rh(90) | 85 |
| 39 | Zr(91) N(9) | 1450 | 64 | Ag(92)) | 86 |
| 40 | Hf(97) N(3) | 1440 | 67 | Os(92) | 84 |
| 41 | Zr(92) N(8) | 1400 | 66 | Pd(90) | 86 |
| 42 | Hf(96) N(4) | 1500 | 67 | Pt(93) | 84 |
| 43 | Zr(80) C(9) N(11) | 2100 | 59 | Pd(90) | 86 |
| 44 | Hf(93) N(7) | 2010 | 61 | Pd(90) | 83 |
| 45 | Ti(79) N(21) | 1960 | 62 | Pd(90) | 86 |
| 46 | Zr(80) C(9) N(11) | 2100 | 59 | Pd(90) | 83 |
| 47 | Zr(88) N(12) | 1960 | 60 | Pt(90) | 83 |

As shown in Table 1 and Table 2, on the surface of Ti, an Ti alloy, SUS304 or SUS316L substrate for the decorative part such as the watch case, the watch band, the watch bezel or the like, the hardening layer was formed by forming the primary layer such as HfN, TiN, TiCN, ZrN or the like, and then forming the reflecting layer and furthermore, forming the finishing layer in coating with the Au or Au alloy layer. In all Examples 1 to 24, the decorate parts had a Vickers hardness Hv of not less than 1500 in the hardness test and were acceptable. Even in the colorimetry evaluating test, the decorative parts that the Ti, Ti alloy, SUS304 or SUS316L substrate having an arithmetical average roughness Ra of 200Å finished by polishing with a No.800 abrasive paper was used had a L* of not less than 83 and were acceptable. Thus, the overall evaluations in Examples 1 to 24 were acceptable and represented by ⊚.

As shown in Table 3 and Table 4, on the surface of a Ti, Ti alloy, SUS304 or SUS316L substrate for the decorative part such as the watch case, the watch band, the watch bezel or the like, the hardening layer was formed by forming the primary layer such as HfN, TiN, TiCN, ZrN or the like, and then forming the reflecting layer and furthermore, forming the finishing layer in coating with the Au or Au alloy layer. Regarding to Examples 25 to 47, in Examples 25 to 27, the decorate parts had a Vickers hardness Hv of not less than 1500 in the hardness test, and were acceptable and represented by ⊚. In the colorimetry evaluating test, the decorative parts had a L* of not less than 83 and were acceptable. In Examples 43 to 47, the decorate parts had a Vickers hardness Hv of not less than 1500 in the hardness test, and were acceptable and represented by ⊚. In the colorimetry evaluating test, the decorative parts had a L* of not less than 82 and less than 83, and were acceptable and represented by ○. In Examples 28 to 42, the decorate parts had a Vickers hardness Hv of not less than 1000 and less than 1500 in the hardness test, and were acceptable and represented by ○. In the colorimetry evaluating test, the decorative parts that the Ti, Ti alloy, SUS304 or SUS316L substrate having an arithmetical average roughness Ra of 200Å finished by polishing with a No. 800 abrasive paper was used had a L* of not less than 83, and were acceptable. Thus, the overall evaluations in Examples 25 to 47 were acceptable.

Meanwhile, in Comparative Examples 1 to 22, the decorate parts had a Vickers hardness Hv of not less than 1500 in the hardness test and were acceptable. In the colorimetry evaluating test, the decorative parts had a L* of less than 82 and were unacceptable. Thus, the overall evaluations in Comparative Examples 1 to 45 were unacceptable.

As is clear from above, the reflecting layer has a thickness of preferably 0.001 µm to 0.01 µm. As compared with a decorative part which reflecting film has a thickness of less than 0.001 µm and a relatively small increase in the L* value or a decorative part which reflecting film has a large thickness of more than 0.01 µm and a low hardness, the decorative parts which reflecting layers have a thickness of 0.001 µm to 0.01 µm can have higher brightness and rigidity.

The finishing layer has a thickness of preferably 0.002 to 0.3 µm. As compared with a finishing layer which has a thickness of less than 0.002 µm and a relatively small increase in the L* value and is apt to show uneven color tone in appearance, or a finishing layer which has a thickness of over 0.3 µm and the same color tone brightness L* as the value of the Au bulk but has low hardness, the finishing layer having a thickness of 0.002 to 0.3 µm can have higher brightness and rigidity.

In the embodiments, Ti, the Ti alloy, SUS304 and SUS316L were used as a substrate material. The substrate material, however, is not limited to these materials. It is possible to use Al, various Al alloys, various stainless steels, various Ti alloys and copper alloys as the substrate material.

In order to attain good adhesion between the substrate and the primary layer such as the nitride layer, the carbide layer or the carbonitride layer, the metal layer made from Hf, Ti or Zr may be previously formed.

In the examples, TiN, HfN, ZrN, TiCN, ZrCN and HfCN were used as the primary layer, but the material of the primary layer is not limited to the above materials. It is possible to use a nitride, a carbide or a carbonitride made from one metal or two or more metals selected from Ti, Zr and Hf.

As a means of evaporating the metals, metal nitrides and Au or Au alloys, the DC sputtering method was employed in the embodiments. This method was employed in order to control the alloy composition easily and the means is not limited to the RF sputtering method and the DC sputtering method. Furthermore, it is possible to employ any sputtering method of DC magnetron sputtering method, RF magnetron sputtering method and the like. Moreover, it is possible to employ other PVD procedures, for examples, dry processes including ion plating method or ion beam vapor deposition method other than the above sputtering methods. Similarly, as the means of generating plasma, any one of the RF method and the DC method may be used.

For the pressure condition for forming the primary layer, the pressure of the gas plasma atmosphere was 0.2 Pa in the embodiments. The pressure of gas plasma atmosphere is not limited to the above condition, and any pressure value may be employed as far as the gas plasma can be generated.

In the embodiments, Ar was used as the inert gas for generating plasma. Moreover, other inert gases such as Xe, Kr or the like may be used in place of Ar or He.

## Claims

1. A decorative part comprising a substrate and, superimposed on the substrate, a hardening layer wherein the hardening layer comprises a primary layer comprising a nitride, a carbide or a carbonitride of one or two or more metals selected from Ti, Zr and Hf, a finishing layer comprising Au or an Au alloy and, disposed between the primary layer and the finishing layer, a reflecting layer comprising a metal having a higher reflectance than one constituting the finishing layer.

2. The decorative part according to claim 1 wherein the reflecting layer comprises one or two or more metals selected from Pt, Ag, Pd, Rh, Os, Ir and Ru.

3. The decorative part according to claim 1 or 2 wherein the reflecting layer has a thickness of 0.001 to 0.02 µm, and the finishing layer has a thickness of 0.001 to 0.85 µm.

4. The decorative part according to any one of claims 1 to 3 wherein the finishing layer comprises Au, an Au-Ni alloy, an Au-Cu alloy or an Au-Cu-Pd alloy.

5. The decorative part according to any one of claims 1 to 4 wherein the primary layer comprises a nitride of Ti, Zr or Hf, or a carbonitride of Ti, Zr or Hf.

6. The decorative part according to any one of claims 1 to 5 wherein the substrate comprises a stainless steel, Ti, a Ti alloy, Al, an Al alloy or a Cu alloy.

7. The decorative part according to any one of claims 1 to 6 wherein the substrate comprises a metal layer of Hf, Ti or Zr.

8. A process for producing a decorative part comprising a substrate and, superimposed on the substrate, a hardening layer obtainable by laminating a primary layer, a reflecting layer and a finishing layer from the substrate side, which process comprising the steps of:
a primary layer laminating step of laminating a primary layer comprising a nitride, a carbide or a carbonitride of one or two or more metals selected from Ti, Zr and Hf on the substrate,
a reflecting layer laminating step of laminating a reflecting layer comprising a metal on the primary layer, and
a finishing layer laminating step of laminating a finishing layer comprising Au or an Au alloy on the reflecting layer,
wherein the metal constituting the reflecting layer has a higher reflectance than a metal constituting the finishing layer.

9. The process for producing a decorative part according to claim 8 wherein the reflecting layer comprises one or two or more metals selected from Pt, Ag, Pd, Rh, Os, Ir and Ru.

10. The process for producing a decorative part according to claim 8 or 9 wherein the reflecting layer has a thickness of 0.001 to 0.02 µm, and the finishing layer has a thickness of 0.001 to 0.85 µm.

11. The process for producing a decorative part according to any one of claims 8 to 10 wherein the finishing layer comprises Au, an Au-Ni alloy, an Au-Cu alloy or an Au-Cu-Pd alloy.

12. The process for producing a decorative part according to any one of claims 8 to 11 wherein the primary layer comprises a nitride of Ti, Zr or Hf, or a carbonitride of Ti, Zr or Hf.

13. The process for producing a decorative part according to any one of claims 8 to 12 wherein the substrate comprises a stainless steel, Ti, a Ti alloy, Al, an Al alloy or a Cu alloy.

14. The process for producing a decorative part according to any one of claims 8 to 13 wherein the substrate comprises a metal layer of Hf, Ti or Zr.

15. The process for producing a decorative part according to any one of claims 8 to 14 wherein the primary layer, the reflecting layer and the finishing layer are laminated by a dry plating method selected from a sputtering method, an ion plating method and an ion beam vapor deposition method.
